# EUROPÄISCHE PATENTSCHRIFT

(11) **EP 1 070 329 B1**
(45) Veröffentlichungstag und Bekanntmachung des Hinweises auf die Patenterteilung: **18.09.2002**
(21) Anmeldenummer: 99924757.0
(22) Anmeldetag: 01.04.1999
(51) Int. Cl.: H01F 27/29, H01F 27/02

(54) **TRÄGERKÖRPER FÜR ELEKTRONISCHE BAUELEMENTE**
SUPPORT FOR ELECTRONIC COMPONENTS
SUPPORT POUR COMPOSANTS ELECTRONIQUES

(30) Priorität: 08.04.1998 DE 19815852
(43) Veröffentlichungstag der Anmeldung: 24.01.2001
(73) Patentinhaber: Vacuumschmelze GmbH, 63450 Hanau (DE)
(72) Erfinder: LABATZKE, Armin, D-61476 Kronberg (DE)
(74) Vertreter: Westphal, Klaus, Dipl.-Ing.
(86) Internationale Anmeldenummer: DE9901007
(87) Internationale Veröffentlichungsnummer: WO99053508

(56) Entgegenhaltungen:
- DE-A- 3 602 759
- US-A- 5 015 981
- US-A- 5 656 985

## Beschreibung

Die Erfindung betrifft einen Trägerkörper aus einer Keramik für elektronische Bauelemente.

Trägerkörper für elektronische Bauelemente, wie z.B. Induktivitäten, bestehen vielfach aus Kunststoffen. Vorteile von Kunststoff als Material für den Trägerkörper sind geringe Kosten, leichte Verarbeitbarkeit und geringes Gewicht. So werden beispielsweise induktive Bauelemente für ISDN-Anwendungen in marktüblichen Bauformen in Stift-Ausführung, SMD-Ausführung oder in für PCMCIA-Karten geeigneten Bauformen hergestellt. Entsprechende Bauformen sind beispielsweise aus der Firmenschrift "ISDN-Bauelemente", Fa. Vacuumschmelze GmbH, Hanau, 1996 bekannt. Derartige Trägerkörper weisen elektrische Anschlüsse auf, die beispielsweise durch Löten mit den Leiterbahnen einer Platine verbunden werden können.

Im Zuge der technischen Weiterentwicklung werden in neuerer Zeit vorwiegend Gehäusebauformen in SMD-Technik, welche oberflächenmontierbar sind, eingesetzt. Zur Montage der Bauelemente auf einer Platinenoberfläche ist es wünschenswert, daß die bei der Bestückung mit der Platine in Kontakt tretenden Flächen bzw. elektrische Anschlüsse des Bauelements möglichst plan auf der ebenen Platinenoberfläche aufliegen. Bei der SMD-Montagetechnik ergeben sich Vorteile, wenn die Planheit dieser Flächen möglichst groß ist. Bezüglich der Planheit sind jedoch die vorstehend genannten Trägerkörper aus Kunststoff mit Nachteilen behaftet. Werden die metallischen Anschlußstifte mit den Anschlußdrähten eines elektrischen Bauelementes beispielsweise durch Löten verbunden, kommt es durch die Erwärmung im Bereich der Stifte beim Löten zu einer Verringerung der Planheit. Auch kommt es während der nachfolgenden Auflötung auf die Platine von Zeit zu Zeit zu einem Aufblähen des Gehäuses durch Erwärmung des gesamten Gehäuses.

Ein weiterer Nachteil ist der vergleichsweise hohe Bedarf an Lötmittel während der Bestückung der Platine.

Trägerkörper aus Keramik sind aus der Informationsschrift "Keramische Werkstoffe für die Elektronik", Informationszentrum Technische Keramik, Selb, 1996 bekannt. Die beschriebenen keramischen Materialien aus Aluminiumoxid oder Aluminiumnitrid werden als Substrate für elektronische Schaltungen und als Gehäuse für Halbleiterschaltungen oder Thyristoren und Dioden eingesetzt. Bei den beschriebenen Gehäusen handelt es sich um Dual-Inline-Gehäuse (DIL) oder Chip Carrier für die Oberflächenmontage nach der SMD-Technik.

Aus einem Firmenprospekt der Firma CeramTec AG, Marktredwiz, 1996 sind keramische Trägerkörper für elektrische Spulen bekannt. Bei diesen Trägerkörpern handelt es sich um brückenförmige Elemente, die das induktive Bauelement umschließen. Die Zuleitungen des induktiven Bauelements, wie beispielsweise die Anschlußdrähte einer im Inneren des Trägerkörpers befindlichen Spule, können mit den metallisierten Flächen des brückenförmigen Trägerkörpers nur auf der dem Platinenmaterial zugewandten Ebene des Trägerkörpers verbunden werden. Auf dieser Ebene befinden sich hierzu sektorenweise metallbeschichtete Flächenelemente. Die Verbindung der Zuleitungen mit den metallbeschichteten Flächen erfolgt somit im Bereich der Lötstellen.

Die Anforderungen, die bei der SMD-Technik an einen Trägerkörper für elektronische Bauelemente gestellt werden, lassen sich mit den vorstehend beschriebenen Ausführungsformen nur unzureichend erfüllen. Insbesondere hinsichtlich der Planheit der dem Platinenmaterial zugewandten metallischen Flächen des keramischen Trägerkörpers sind die herkömmlich konstruierten Trägerkörper den gestellten Anforderungen nicht immer gewachsen. Zur Ausnutzung der Vorteile der SMD-Montagetechnik ist somit eine möglichst geringe Schwankung der Planheit der Bauelemente im Bereich der metallischen Flächen von Vorteil.

Aufgabe der vorliegenden Erfindung ist die Bereitstellung eines Trägerkörpers, der die vorstehend genannten Nachteile bekannter Trägerkörper nicht aufweist.

Die erfindungsgemäße Aufgabe wird gelöst durch einen Trägerkörper aus einer Keramik für elektronische Bauelemente mit mindestens zwei voneinander elektrisch isolierten Kontaktflächen 2, wobei die Kontaktflächen auf einer gemeinsamen Ebene des Trägerkörpers angeordnet sind, welcher dadurch gekennzeichnet ist, daß sich auf mindestens einer Fläche des Trägerkörpers, welche nicht parallel zur gemeinsamen Ebene der Kontaktflächen 2 verläuft, weitere metallisierte Oberflächen 3 befinden, wobei jeweils eine metallisierte Oberfläche mit einer der Kontaktflächen 2 leitfähig verbunden ist.

Unter dem Begriff "Kontaktflächen" werden gemäß der Erfindung metallisierte Oberflächenschichten, die sich auf der Oberfläche des Trägerkörpers befinden und für die Verbindung des Trägerkörpers mit einem Platinenmaterial vorgesehen sind, verstanden. Die Kontaktflächen sind daher planparallel zueinander angeordnet. Die Form der Kontaktflächen ist beliebig. Sie können je nach der gewünschten Anforderung beispielsweise quadratisch, rechteckig, rund oder auch n-eckig sein. Auch unterschiedliche Formen von Kontaktflächen auf einem Trägerkörper sind denkbar.
Die Breite der Kontaktflächen 2 liegt bevorzugt in einem Bereich von 0,1 bis 5 mm. Für die Länge der Kontakflächen ist ein Bereich von 0,5 bis 10 mm bevorzugt.

Die gemeinsame Ebene, auf denen sich die Kontaktflächen befinden, entspricht in der Regel der Unterseite des Trägerkörpers, also der dem Platinenmaterial zugewandten Seite.

Die auf dem Trägerkörper befindlichen metallisierten Schichten im Bereich der Kontaktflächen 2 oder der metallisierten Oberflächen 3 bestehen im wesentlichen aus einem leitfähigen Material, wie beispielsweise Cu, Ni, Au, C, W, Pt, Ag etc. Es ist möglich, daß die Herstellung dieser Beschichtung so erfolgt, daß zunächst eine oder mehrere Zwischenschichten aufgebracht werden und als letzte Schicht die leitende metallisierte Schicht. Geeignete Verfahren zur Beschichtung von keramischen Materialien mit leitfähigen Schichten sind an sich bekannt. Die Dicke der metallisierten Schicht liegt vorzugsweise in einem Bereich von 0,1 bis 40 µm.

Vorzugsweise weist der Trägerkörper ein Dachelement 13 mit einem auf der Innenfläche des Dachelements 11 angeordneten induktiven Bauelement 17 auf. Es ist jedoch ebensogut möglich, das das Bauelement an einer anderen Fläche des Trägerkörpers, beispielsweise an einer Wand befestigt ist.

Die geometrische Form des erfindungsgemäßen. Trägerkörpers muß so gewählt werden, daß die metallisierten Oberflächen 3 nicht im Bereich der Kontaktflächen 2 liegen. Daher verlaufen die nicht parallel zur gemeinsamen Ebene der Kontaktflächen 2 verlaufenden Flächen, auf denen sich die metallisierten Oberflächen 3 befinden, vorzugsweise in einem Winkel von 90° bezüglich der gemeinsamen Ebene der Kontaktflächen 2.

Vorzugsweise weist der erfindungsgemäße Trägerkörper zwei in einem Winkel von 90° zur gemeinsamen Ebene der Kontaktflächen 2 verlaufende Wände 12 auf, ein Dachelement 13, welches senkrecht zu den Wänden und parallel zur gemeinsamen Ebene der Kontaktflächen 2 angeordnet ist und zwei Stirnwände 5, die senkrecht zum Dachelement und den Wänden angeordnet sind. Ein Beispiel für eine geometrische Form dieser Art ist ein einseitig offener Quader mit rechtwinkligen Flächen, der die Form eines Schuhkartons hat.

Zwischen den metallisierten Kontaktflächen 2 und den metallisierten Oberflächen 3 befinden sich vorzugsweise nutförmige Vertiefungen 4, die beispielsweise durch Schleifen, Sägen oder Fräsen in das Keramikmaterial eingebracht werden können.

Diese nutförmigen Vertiefungen sind nicht metallisiert. Es ist auch möglich, daß der Formkörper bei der Herstellung beispielsweise nach einem üblichen keramischen Herstellungsverfahren nach dem Brennen bereits entsprechende nutförmige Vertiefungen aufweist. Der Abstand der nutförmigen Vertiefungen liegt vorzugsweise in einem Bereich zwischen 0,2 und 5 mm.

Vorzugsweise sind nutförmige Vertiefungen 4 auf der gemeinsamen Ebene der Kontaktflächen 2 angeordnet und weitere nutförmige Vertiefungen 4 auf den nicht parallel zu der gemeinsamen Ebene der Kontaktflächen verlaufenden Ebenen. Diese auf verschiedenen Ebenen angeordneteten nutförmigen Vertiefungen 4 bilden im Bereich der Kanten Nutkanten 15.

Wenn an den erfindungsgemäßen Trägerkörper ein Anschlußdraht 7 beispielsweise von einer Spule verbunden werden soll, so wird vorzugsweise dieser Anschlußdraht 7 mit einer metallisierten Oberfläche 3 elektrisch leitend verbunden.

Der besagte Anschlußdraht wird zweckmäßigerweise durch die Nutkante 15 so geführt daß der Draht in den Nutkanten 15 eine mechanische Lokalisierung erfährt. Diese Maßnahme entlastet einen gegebenenfalls vorhandenen Kontakt und schützt den Draht vor dem Verrutschen.

Vorzugsweise ist der durch die Nutkante 15 geführte Anschlußdraht 7 an einer zur entsprechenden nutförmigen Vertiefung direkt benachbarten metallisierten Oberfläche 3 leitend verbunden.

Die Kontaktflächen des erfindungsgemäßen Trägerkörpers sind sehr präzise hergestellt und weisen daher eine hohe Planheit auf. Die Koplanarität der planparallelen Kontaktflächen 2 bestimmt nach der weiter oben beschriebenen Methode beträgt vorzugsweise weniger als 30 µm.

Weist der Trägerkörper ein parallel zur gemeinsamen Ebene der Kontaktflächen 2 verlaufendes Dachelement 13 auf, so kann in Richtung des Innenraums 6 auf der Innenfläche des Dachelements 11 eine Befestigungseinrichtung vorhanden sein. Die Befestigungseinrichtung kann eine beispielsweise zur Befestigung einer Spule dienen. Vorzugsweise handelt es sich bei der Befestigungseinrichtung um einen Kegelstumpf 10.

Vorzugsweise ist auf der besagten Innenfläche des Dachelements 11 ein Kern 9 mit einer Wicklung 14 angeordnet.

Das induktive Bauelement (17) ist auf der Innenfläche der Oberseite zweckmäßigerweise noch befestigt, beispielsweisemit einem üblichen Kleber. Besonders bevorzugt ist es, wenn der Innenraum mit dem Kleber vergossen ist.

An den auf der Unterseite des Trägerkörpers angeordneten Kontaktflächen (2) sind vorzugsweise keine Zuleitungsdrähte für elektrische Bauelemente angebracht oder kontaktiert. Wenn ein Anschlußdraht mit dem Trägerkörper gemäß der Erfindung verbunden wird, erfolgt die Verbindung mit den leitenden Flächen über die beispielsweise an der Seite des Bauelemente befindlichen metallisierten Oberflächen (3).

Die Bestimmung der Koplanarität erfolgt nach einem Laserabstandsmeßverfahren. Nach diesem Verfahren werden zunächst die Höhen der dem Platinenmaterial zugewandten metallisierten Flächen in einer Richtung senkrecht zur gemeinsamen Ebene der Kontaktflächen (Z-Richtung) bestimmt. Dabei wird so vorgegangen, daß die Meßwerte der Höhe in Z-Richtung in definierten Abständen von der Vorderkante des Trägerkörpers bestimmt werden. Aus diesen Z-Meßwerten wird eine Ausgleichebene nach Gauß errechnet. Die Koplanarität ist die Summe der Beträge der maximalen und der minimalen Abweichung dieser Werte von der berechneten mittleren Ausgleichebene.

Die erfindungsgemäßen Trägerkörper weisen vorzugsweise eine Koplanarität von weniger als 100 µm, insbesondere weniger als 50 µm auf. Ganz besonders bevorzugt ist es, wenn die Koplanarität unterhalb 30 µm liegt.

Die vorliegende Erfindung betrifft auch ein elektronisches Bauteil, welches einen erfindungsgemäßen Trägerkörper enthält. Dies Bauteil ist dadurch gekennzeichnet, daß im Trägerkörper ein elektronisches Bauelement, wie beispielsweise ein umwickelter Kern vorhanden ist.

Ferner betrifft die Erfindung die Verwendung des erfindungsgemäßen Trägerkörpers für induktive Bauelemente, wie beispielsweise Schnittstellen-Übertrager, Schnittstellen-Module, stromkompensierte Drosseln, Leistungsübertrager, Ansteuertransformatoren für Transistoren, Speicher- und Siebdrosseln, Transduktordrosseln, Stromtransformatoren, Stromsensoren, Spannungstransformatoren, Ansteuerübertrager für GTO/IGBT/SIPMOS, Zündübertrager und -bausteine für Thyristoren oder Filter- und Glättungsdrosseln.

Das erfindungsgemäße induktive Bauelement kann nach dem nachfolgend beschriebenen Verfahren, welches ebenfalls Gegenstand der vorliegenden Erfindung ist, hergestellt werden. Das erfindungsgemäße Verfahren umfaßt die Schritte:
- Befestigung eines induktiven Bauelements 17 auf der Innenfläche eines Trägerkörpers nach Anspruch 1,
- Führung der Drähte 7 des induktiven Bauelements über die Nutkanten 15,
- Führung der Drähte 7 in einem Winkel über die Kontaktflächen 2,
- Kontaktierung des Drahtes 7 mit der metallisierten Oberfläche 3 und gegebenenfalls Entfernung der über die Kontaktflächen 2 hinausstehenden Drahtenden 7.

### Beispiel

### Messung der Koplanarität an 50 Trägerkörpern gemäß der Erfindung.

Die Koplanarität wurde an 50 Trägerkörpern mit jeweils 8 metallisierten Flächen gemäß der Erfindung nach der weiter oben beschriebenen Methode bestimmt. Alle Trägerkörper wiesen eine Koplanarität von weniger als 14 µm auf.
Zusätzlich wurde aus den Einzelmesswerten der Abstände der einzelnen Kontaktflächen von der gemittelten Ausgleichsebene (Z-Meßwerte) ein Datensatz gebildet. Die Anzahl der Meßwerte betrug 8 x 50 = 400. Die Häufigkeitsverteilung dieser gemessenen Einzelabstände von den Ausgleichebenen entsprach einer Gauß-Verteilung. Die Standardabweichung der Gauß-Verteilung betrug 4,28 µm.

Anhand der Figuren 1 bis 3 wird nun die vorliegende Erfindung näher erläutert.
- Figur 1: zeigt einen erfindungsgemäßen Trägerkörper in schematischer Darstellung.
- Figur 2: stellt den Trägerkörper von Figur 1 aus einer Ansicht von oben dar. Die dem Platinenmaterial zugewandten Flächen befinden sich auf der unteren Seite.
- Figur 3: zeigt den erfindungsgemäßen Trägerkörper der Figur 1 von der Seite. Zusätzlich sind mit dem Trägerkörper kontaktierte und unkontaktierte Drähte eingezeichnet.

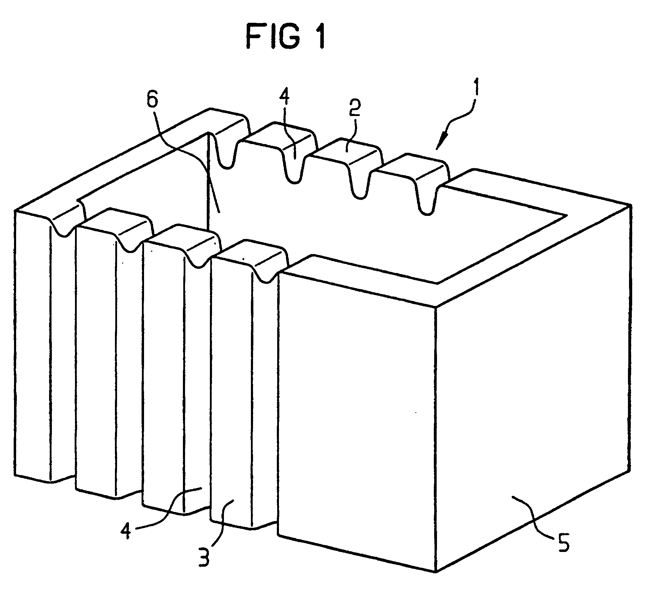

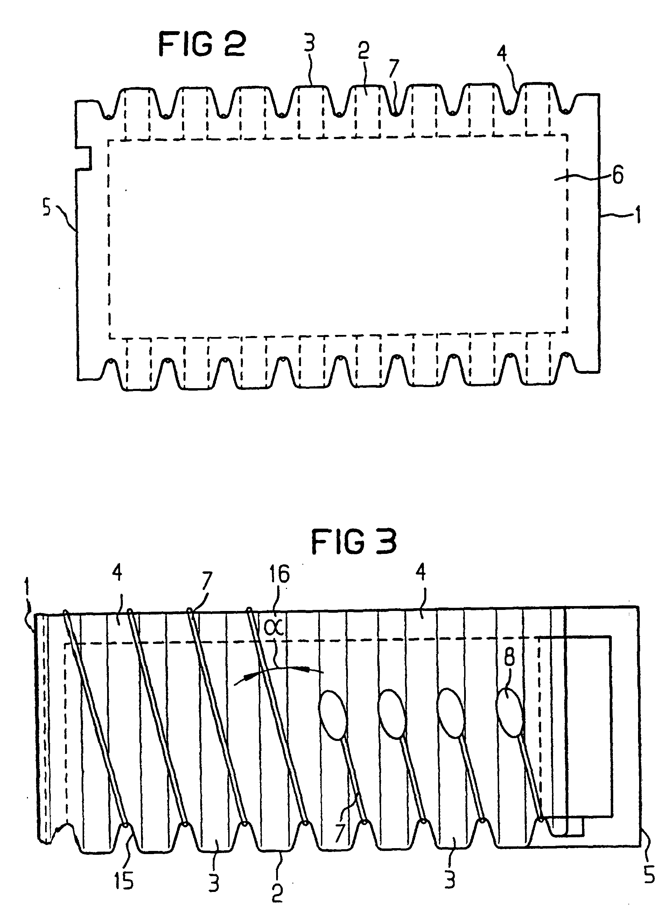

Der keramische Träger 1 in Figur 1 ist quaderförmig ausgebildet und umfaßt vier Seitenflächen und eine ein Dach bildende Fläche. Das keramische Material kann beispielweise Aluminiumoxid oder Aluminiumnitrid sein. Auf der dem Platinenmaterial zugewandten Ebene befinden sich rasterförmig angeordnete Flächen 2. Die Flächen 2 sind metallisch beschichtet. Zwischen den segmentweise angeordneten Flächen 2 befinden sich Rinnen 4, welche Vertiefungen darstellen, die beispielsweise durch Fräsen oder Schleifen in die Wandung eingebracht werden können. Die Rinnen 4 setzen sich über die seitlichen Wandungen nach oben hin fort. Zwischen den auf der seitlichen Wand befindlichen Rinnen befinden sich metallisierte Oberflächen 3. Die metallisierten Oberflächen 3 sind elektrisch leitend mit den Kontaktflächen 2 verbunden. Die metallischen Schichten lassen sich auf im Stand der Technik übliche Weise auf den keramischen Trägerkörper aufbringen. Die Aufsicht in Figur 2 stellt die Rinnen 4 und die seitlichen metallisierten Oberflächen 3 dar. Innerhalb der Rinnen 4 bzw. Nuten ist ein Kupferlackdraht 7, welcher mit dem nicht dargestellten induktiven Bauteil verbunden ist, eingezeichnet.

Die Seitenansicht des erfindungsgemäßen Trägerkörper in Figur 3 zeigt, wie die Kupferlackdrähte über die Nutkante 15 verlaufen. Der Draht 7 ist um die Nutkante 15 herumgezogen und verläuft in einem Winkel 16 von mehr als 0° und weniger als 90° bezüglich der Längsachse der metallisierten Flächen über die metallisierten Oberflächen 3. Der keramische Träger 1 ermöglicht eine maschinelle Kontaktierung der Drähte 7 mit den Kontaktflächen 2 auf besonders einfache Weise. Bei diesem Verfahren werden zunächst die Drähte 7, welche mit einer Induktivität verbunden sein können, über die Nutkanten 15 geführt und parallel zur Seitenfläche des keramischen Trägers im besagten Winkel 16 geführt. Anschließend wird im Bereich der metallisierten Oberfläche 3 der Draht mit der metallisierten Oberfläche leitend verbunden. Die überstehenden Drahtenden werden entweder entfernt oder trennen sich bei der Kontaktierung automatisch ab. Hierdurch ist es möglich, die mechanische Beanspruchung der Kontakte 8 zu verringern. Die Führung des Drahts in Nuten 4 bzw. über Nutkanten 15 verhilft zu einer mechanischen Fixierung des Drahtes 7. Die Kontaktierung kann beispielsweise durch Schweißen erfolgen.

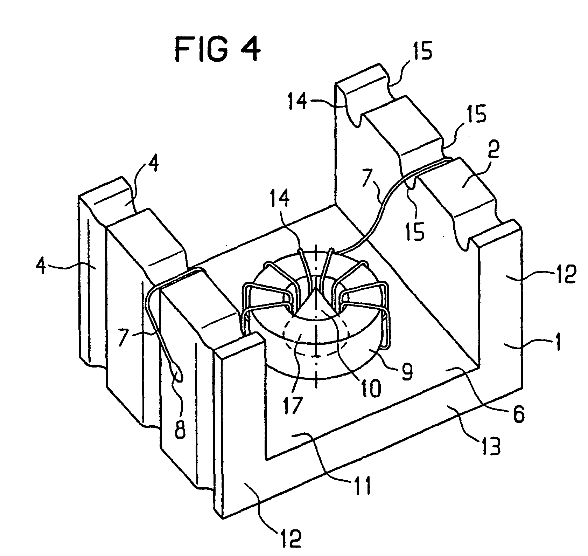

Figur 4 zeigt eine weitere Ausführungsform für einen erfindungsgemäßen Trägerkörper ohne Stirnwände 5. Auf der Innenfläche der Oberseite des Trägerkörpers befindet sich ein eingearbeiteter Kegel, welcher aus dem gleichen Material wie der Träger besteht. Auf den Kegel 10 ist ein ringförmiger Magnetkern 9 aufgesteckt, welcher beispielsweise durch eine übliche Klebemasse befestigt werden kann. Die Anschlüsse der Wicklung 14 mit den Zuleitungen 7 sind über die Nutkanten 15 geführt und enden an den Kontakten 8.

Gegenüber Trägerkörpern aus Kunststoff besitzen keramische Trägerkörper den Vorteil einer weitaus erhöhten Temperaturbeständigkeit und einer verringerten Feuchtigkeitempfindlichkeit.

Die geringe Koplanarität der erfindungsgemäßen Trägerkörper verhilft dem elektronischen Bauteil bei der Montage auf einer Platine zu einer verbesserten Benetzbarkeit der metallisierten Anschlußflächen. Hierdurch kann die Schichtdicke des eingesetzten Lotmaterials reduziert werden und die Verarbeitbarkeit insbesondere von Bauelementen mit kleinem Rastermaß, wie vorzugsweise weniger als etwa 0,2 mm, besonders bevorzugt weniger als 0,13 mm, wesentlich erleichtert werden.

Ein weiterer Vorteil des erfindungsgemäßen Trägerkörpers gegenüber bekannten Trägerkörpern ist, daß die Führung der Anschlußdrähte eines Bauelementes in den Nutkanten (15) eine über die übliche Befestigung an der Kontaktstelle hinausgehende mechanische Befestigung des Drahtes bewirkt. Durch diese Maßnahme läßt sich eine nahezu vollständige mechanische Entlastung des elektrischen Kontakts mit einer einhergehenden weitaus geringen Häufigkeit von Beschädigungen im Bereich des Kontaktes erreichen.

## Patentansprüche

1. Trägerkörper aus einer Keramik für elektronische Bauelemente mit mindestens zwei voneinander elektrisch isolierten Kontaktflächen (2), wobei die Kontaktflächen auf einer gemeinsamen Ebene des Trägerkörpers angeordnet sind,
**dadurch gekennzeichnet, daß** sich auf mindestens einer Fläche des Trägerkörpers, welche nicht parallel zur gemeinsamen Ebene der Kontaktflächen (2) verläuft, weitere metallisierte Oberflächen (3) befinden, wobei jeweils eine metallisierte Oberfläche mit einer der Kontaktflächen (2) leitfähig verbunden ist.

2. Trägerkörper nach Anspruch 1,
**dadurch gekennzeichnet, daß** der Trägerkörper ein Dachelement (13) aufweist, wobei auf der Innenfläche des Dachelements (11) ein induktives Bauelement (17) angeordnet ist.

3. Trägerkörper nach Anspruch 1 oder 2,
**dadurch gekennzeichnet, daß** die nicht parallel zur gemeinsamen Ebene der Kontaktflächen (2) verlaufenden Flächen, auf denen sich die metallisierten Oberflächen (3) befinden, in einem Winkel von 90° zur gemeinsamen Ebene der Kontaktflächen (2) verlaufen.

4. Trägerkörper nach mindestens einem der Ansprüche 1 bis 3,
**dadurch gekennzeichnet, daß** der Trägerkörper zwei in einem Winkel von 90° zur gemeinsamen Ebene der Kontaktflächen (2) verlaufende Wände (12) aufweist, ein Dachelement (13), welches senkrecht zu den Wänden und parallel zur gemeinsamen Ebene der Kontaktflächen (2) angeordnet ist und zwei Stirnwände (5), die senkrecht zum Dachelement und den Wänden angeordnet sind.

5. Trägerkörper nach mindestens einem der Ansprüche 1 bis 4,
**dadurch gekennzeichnet, daß** sich zwischen den metallischen Kontaktflächen (2) und den metallisierten Oberflächen (3) nutförmige Vertiefungen (4) befinden, wobei die nutförmigen Vertiefungen nicht metallisiert sind.

6. Trägerkörper nach Anspruch 5,
**dadurch gekennzeichnet, daß** nutförmige Vertiefungen (4) auf der gemeinsamen Ebene der Kontaktflächen (2) angeordnet sind und weitere nutförmige Vertiefungen (4) auf den nicht parallel zu der gemeinsamen Ebene der Kontaktflächen verlaufenden Ebenen befinden, wobei diese auf verschiedenen Ebenen angeordneteten nutförmigen Vertiefungen (4) Nutkanten (15) bilden.

7. Trägerkörper nach mindestens einem der Ansprüche 1 bis 6,
**dadurch gekennzeichnet, daß** ein Anschlußdraht (7) mit einer metallisierten Oberfläche (3) elektrisch leitend verbunden ist.

8. Trägerkörper nach mindestens einem der Ansprüche 1 bis 7,
**dadurch gekennzeichnet, daß** durch die Nutkante ein Anschlußdraht (7) geführt ist, so daß der Draht in den Nutkanten (15) eine mechanische Lokalisierung erfährt.

9. Trägerkörper nach Anspruch 8,
**dadurch gekennzeichnet, daß** der durch die Nutkante (15) geführte Anschlußdraht (7) an einer zur entsprechenden nutförmigen Vertiefung direkt benachbarten metallisierten Oberfläche (3) leitend verbunden ist.

10. Trägerkörper nach mindestens einem der Ansprüche 1 bis 9,
**dadurch gekennzeichnet, daß** die Koplanarität der planparallelen Kontaktflächen (2) weniger als 100 µm beträgt, wobei die Kopolanarität der maximale Abstand von einer Ebene ist, die parallel zu den Kontaktflächen (2) liegt und welche durch Mittelwertbildung aus den einzelnen Höhen der Kontaktflächen (2) berechnet worden ist.

11. Trägerkörper nach mindestens einem der Ansprüche 1 bis 10,
**dadurch gekennzeichnet, daß** ein parallel zur gemeinsamen Ebene der Kontaktflächen (2) verlaufendes Dachelement (13) vorhanden ist und in Richtung des Innenraums (6) auf der Innenfläche des Dachelements (11) ein Kegelstumpf (10) angeordnet ist.

12. Trägerkörper nach mindestens einem der Ansprüche 1 bis 11,
**dadurch gekennzeichnet, daß** ein parallel zur gemeinsamen Ebene der Kontaktflächen (2) verlaufendes Dachelement (13) vorhanden ist und in Richtung des Innenraums (6) auf der Innenfläche des Dachelements (11) ein Kern (9) mit einer Wicklung (14) angeordnet ist.

13. Elektronisches Bauteil,
**dadurch gekennzeichnet, daß** es einen Trägerkörper gemäß Anspruch 1 enthält.

14. Verwendung des Trägerkörpers nach Anspruch 1 für induktive Bauelemente.

15. Verfahren zur Herstellung eines induktiven Bauelements umfassend die Schritte:
- Befestigung eines induktiven Bauelements (17) auf der Innenfläche eines Trägerkörpers nach Anspruch 1,
- Führung der Drähte (7) des induktiven Bauelements über die Nutkanten (15),
- Führung der Drähte (7) in einem Winkel über die Kontaktfläche (2),
- Kontaktierung des Drahtes (7) mit der metallisierten Oberfläche (3) und gegebenenfalls Entfernung der über die Kontaktflächen (2) hinausstehenden Drahtenden (7).

## Claims

1. Ceramic support for electronic components, comprising at least two contact surfaces (2) electrically insulated relative to one another, the contact surfaces being arranged on a common plane of the support, **characterised in that** further metallised surfaces (3) are situated on at least one surface of the support which does not extend parallel to the common plane of the contact surfaces (2), each metallised surface being conductively connected to one of the contact surfaces (2).

2. Support according to claim 1, **characterised in that** the support has a roof element (13), an inductive component (17) being arranged on the inner surface (11) of the roof element.

3. Support according to claim 1 or claim 2, **characterised in that** the surfaces not extending parallel to the common plane of the contact surfaces (2) on which the metallised surfaces (3) are situated extend at an angle of 90° relative to the common plane of the contact surfaces (2).

4. Support according to at least one of claims 1 to 3, **characterised in that** the support has two walls (12) extending at an angle of 90° relative to the common plane of the contact surfaces (2), a roof element (13) arranged perpendicularly to the walls and parallel to the common plane of the contact surfaces (2) and two end walls (5) arranged perpendicularly to the roof element and the walls.

5. Support according to at least one of claims 1 to 4, **characterised in that** groove-shaped recesses (4) are situated between the metallic contact surfaces (2) and the metallised surfaces (3), the groove-shaped recesses not being metallised.

6. Support according to claim 5, **characterised in that** groove-shaped recesses (4) are arranged on the common plane of the contact surfaces (2) and further groove-shaped recesses (4) are situated on the planes not extending parallel to the common plane of the contact surfaces, these groove-shaped recesses (4) arranged on different planes forming grooved edges (15).

7. Support according to at least one of claims 1 to 6, **characterised in that** a connecting wire (7) is electroconductively connected to a metallised surface (3).

8. Support according to at least one of claims 1 to 7, **characterised in that** a connecting wire (7) is guided through the grooved edge in such a manner that the wire is fixed mechanically in position in the grooved edges (15).

9. Support according to claim 8, **characterised in that** the connecting wire (7) guided through the grooved edge (15) is conductively connected to a metallised surface (3) directly adjacent to the corresponding groove-shaped recess.

10. Support according to at least one of claims 1 to 9, **characterised in that** the coplanarity of the plane parallel contact surfaces (2) is less than 100 µm, the coplanarity being the maximum distance from a plane situated parallel to the contact surfaces (2) and being calculated by averaging the individual heights of the contact surfaces (2).

11. Support according to at least one of claims 1 to 10, **characterised in that** a roof element (13) extending parallel to the common plane of the contact surfaces (2) is provided and a truncated cone (10) is arranged on the inner surface (11) of the roof element in the direction of the interior (6).

12. Support according to at least one of claims 1 to 11, **characterised in that** a roof element (13) extending parallel to the common plane of the contact surfaces (2) is provided and a core (9) with a winding (14) is arranged on the inner surface (11) of the roof element in the direction of the interior (6).

13. Electronic component, **characterised in that** it contains a support according to claim 1.

14. Use of the support according to claim 1 for inductive components.

15. Process for the production of an inductive component including the steps:
- fixing an inductive component (17) to the inner surface of a support according to claim 1,
- guiding the wires (7) of the inductive component over the grooved edges (15),
- guiding the wires (7) at an angle over the contact surface (4),
- contacting the wire (7) with the metallised surface (3) and, if necessary, removing the ends of the wires (7) projecting beyond the contact surfaces (8).

## Revendications

1. Support en céramique pour composants électroniques avec au moins deux surfaces de contact (2) électriquement isolées l'une de l'autre, les surfaces de contact étant placées sur un plan commun du support,
**caractérisé en ce qu'**
il y a sur au moins l'une des surfaces du support qui n'est pas parallèle au plan commun des surfaces de contact (2) d'autres surfaces 3 métallisées, chacune des surfaces (3) métallisées étant liée de façon conductrice à une surface de contact (2).

2. Support selon la revendication 1,
**caractérisé en ce que**
le support présente un élément de toit (13), un composant (17) inductif étant placé sur la surface interne de l'élément de toit (11).

3. Support selon la revendication 1 ou 2,
**caractérisé en ce que**
les surfaces qui ne sont pas parallèles au plan commun des surfaces de contact (2) et sur lesquelles se trouvent les surfaces (3) métallisées forment un angle de 90° par rapport au plan commun des surfaces de contact (2).

4. Support selon au moins l'une des revendications 1 à 3,
**caractérisé en ce que**
le support présente deux parois (12) qui forment un angle de 90° par rapport au plan commun des surfaces de contact (2), un élément de toit (13) qui est disposé perpendiculairement aux parois et parallèlement au plan commun des surfaces de contact (2) et deux parois frontales (5) qui sont disposées perpendiculairement à l'élément de toit et aux parois.

5. Support selon au moins l'une des revendications 1 à 4,
**caractérisé en ce qu'**
entre les surfaces de contact (2) métallisées et les surfaces (3) métallisées se trouvent des cavités (4) en forme de rainure, les cavités en forme de rainure n'étant pas métallisées.

6. Support selon la revendication 5,
**caractérisé en ce que**
les cavités (4) en forme de rainure sont disposées sur le plan commun des surfaces de contact (2) et les autres cavités (4) en forme de rainure sur les plans non parallèles au plan commun des surfaces de contact, ces cavités (4) en forme de rainure disposées sur plusieurs plans formant des arêtes en rainure (15).

7. Support selon au moins l'une des revendications 1 à 6,
**caractérisé en ce qu'**
une sortie (7) est reliée de façon électriquement conductrice avec une surface (3) métallisée.

8. Support selon au moins l'une des revendications 1 à 7,
**caractérisé en ce qu'**
une sortie (7) est passée à travers l'arête en rainure pour que le fil soit mécaniquement positionné dans l'arête en rainure (15).

9. Support selon la revendication 8,
**caractérisé en ce que**
la sortie (7) passée à travers l'arête en rainure (15) est reliée de façon conductrice à une surface (3) métallisée placée à proximité immédiate de la cavité en forme de rainure correspondante.

10. Support selon au moins l'une des revendications 1 à 9,
**caractérisé en ce que**
la coplanarité des surfaces de contact (2) à faces planes et parallèles est inférieure à 100 µm, la coplanarité étant l'écart maximal d'un plan qui est parallèle aux surfaces de contact (2) qui a été calculé à l'aide d'une moyenne issue des différentes hauteurs des surfaces de contact (2).

11. Support selon au moins l'une des revendications 1 à 10,
**caractérisé par**
la présence d'un élément de toit (13) qui court parallèlement au plan commun des surfaces de contact (2) et la présence d'un cône tronqué (10) sur la surface intérieure de l'élément de toit (11) en direction de l'espace intérieur (6).

12. Support selon au moins l'une des revendications 1 à 11,
**caractérisé par**
la présence d'un élément de toit (13) qui court parallèlement au plan commun des surfaces de contact (2) et par la présence d'un noyau (9) sur la surface intérieure de l'élément de toit (11) avec un enroulement (14) en direction de l'espace intérieur (6).

13. Composant électronique,
**caractérisé en ce qu'**
il contient un support selon la revendication 1.

14. Utilisation du support selon la revendication 1 pour des composants inductifs.

15. Procédé pour fabriquer un composant inductif comprenant les étapes suivantes :
- fixation d'un composant (17) inductif sur la surface intérieure d'un support selon la revendication 1,
- passage des fils (7) du composant inductif sur les arêtes en rainure (15),
- passage des fils (7) selon un angle sur les surfaces de contact (4),
- mise en contact du fil (7) avec la surface (3) métallisée et éventuellement élimination des extrémités des fils (7) dépassant des surfaces de contact (8).
